# EUROPEAN PATENT APPLICATION

(11) **EP 4 611 023 A1**
(43) Date of publication of application: **03.09.2025**
(21) Application number: 25160514.3
(22) Date of filing: 27.02.2025
(51) Int. Cl.: H01L 21/48, H01L 23/495, H01L 23/00

(54) **METHOD OF MANUFACTURING SEMICONDUCTOR DEVICES AND CORRESPONDING DEVICE**

(30) Priority: 29.02.2024 IT 202400004438
(71) Applicant: STMicroelectronics International N.V., 1228 Plan-les-Ouates, Geneva (CH)
(72) Inventor: MAZZOLA, Mauro, I-24040 Calvenzano (Bergamo) (IT); DE SANTA, Matteo, I-20883 Mezzago (Monza Brianza) (IT)
(74) Representative: Buzzi, Notaro & Antonielli d'Oulx S.p.A.

(57) **Abstract**

One or more integrated circuit semiconductor dice (14) are arranged on a substrate (12) having electrically conductive leads (12B). Electrical coupling of the semiconductor die or dice (14) is provided via electrically conductive ribbons (18) having a first end portion (181) electrically coupled to a semiconductor die (14) and a second end portion (182) electrically coupled to a lead (12B), respectively.

The first end portion (181) of the electrically conductive ribbon (18) is ultrasonically coupled (bonded) to the semiconductor die (14), and the second end portion (182) of the electrically conductive ribbon (18) is coupled to the lead (12B) via electrically conductive material, such as film or tape (200) or glue/solder paste (200A, 200B) added at the second end portion 182 of the electrically conductive ribbon (18).

## Description

### Technical field

The description relates to manufacturing semiconductor devices.

Solutions as described herein can be applied to power (integrated circuit) semiconductor devices such as power QFN packages, for automotive products, for instance.

### Background

In power integrated circuit semiconductor devices, the current transferred from a high-power section to output pads of the device can be significant. Clips or ribbons can be used for that purpose in the place of wires.

Clips are currently stamped from flat material. Pins with the purpose of centering the clip on the leadframe can also be created in the clip material by punching. Recesses are created at corresponding leadframe positions to house the clip pins for centering purposes.

In small packages (power Quad-Flat No Leads - QFN packages, for instance) and/or if several channels are desired to be provided in the final package, more pads are needed and the dimensions for recesses on leadframe and clips may become relatively small. The relatively small dimensions may lead to difficulties in clips manufacturing and handling.

Another approach in providing electrical coupling of a power section of a (integrated circuit, IC) semiconductor device and outer pins or pads is based on the use of electrically conductive ribbons

These ribbons are portions of flat wire, of substantially rectangular section, provided in reel format, that can be bonded via ultrasonic wedge-bonding at two coupling locations, before being cut. Ribbon bonding is another coupling technique that may be used for high power connections.

However, such a bonding method may undesirably damage the leadframe (at the relatively small outer pads, for instance).

When a substrate is intended to be used that is expected to be unable to sustain the stress induced by ultrasonic ribbon welding process, clips are used instead of ribbons: clips are connected on both die and lead using solder paste or glue, with no substantial stress applied.

However, clips are sensitive to abrupt movements, so that issues such as clip rotation, offset or tilt may arise.

Combining all the mechanical tolerances on clips and/or leadframe may turn of to be difficult and clips are not cost-competitive due to additional features.

Document US 2013/134577 A1 discloses a flexible conductive ribbon that is ultrasonically bonded to the surface of a die and terminals from a lead frame of a package. Multiple ribbons and/or multiple bonded areas are indicated to provide various benefits, such as high current capability, reduced spreading resistance, reliable bonds due to large contact areas, lower cost and higher throughput due to less areas to bond and test.

Document US 2007/130759 A1 discloses a leadframe having raised features for use a semiconductor device package that is fabricated by bonding together at least two metal layers. A first metal layer may define the lateral dimensions of the leadframe, including any die pad and leads. A second metal layer bonded to the first metal layer, may define the raised features of the leadframe, such as steps for physically securing the leadframe within the package body. The multiple metal layers may be bonded together by a number of possible techniques, including but not limited to ultrasonic welding, soft soldering, or the use of epoxy. Prior to or after bonding, one or more of the metal layers may be coined or stamped to form additional features such as offsets or channels.

In addition to other documents of interest such as US 2011/005813 A1 and US 2021/268598 A1, document US 2009/065910 A1 discusses in the first place electrical connection provided between an element electrode and a lead terminal via a copper coupling conductor that is used as solder, namely by being ostensibly soldered at both ends. Document US 2009/065910 A1 also discusses various other solutions that involve connection by an ultrasonic connecting method at both die (electrode) and lead ends.

Document WO 2012/053129 A1 discloses a multilayer ribbon, for instance made a stack of Aluminium/Copper/Gold, ultrasonically welded both on a die and a lead.

To summarize:
if high currents are transferred from a dice to the outer pads in an (integrated circuit, IC) semiconductor device, clips or ribbons represent advantageous alternatives to wires for electrically connecting these parts in the device;
clips are placed in the proper position through a pick and place step. Clip bonding is performed using solder paste or glue as interface material between the clip itself and the die/lead. Solutions based on clips have various disadvantages, like clip precise placement, possible move during leadframe handling, and cost;
ribbons are advantageous in so far as they can be easily shaped and directly welded to both a die and a leadframe using ultrasonic welding technology. For instance, aluminum or copper ribbons are welded on both die and leadframe using ultrasonic bonding. In some circumstances, the leadframes may not be strong enough to withstand the ultrasonic welding process. Bent/broken leadframes can be observed after a ribbon bonding step.

### Object and summary

Solutions as described herein aim at addressing the issues discussed in the foregoing.

Such an object can be achieved via a method having the features set forth in the claims that follow.

One or more embodiments relate to a corresponding (integrated circuit) semiconductor device.

The claims are an integral part of the technical teaching provided in respect of the embodiments.

In solutions as described herein, electrical coupling between the power section of a semiconductor device and the outer pads is provided via a "hybrid" ribbon bonding technique comprising:
welding the ribbon at die side (sometimes referred to as "first" bond) using standard ultrasonic bonding technology, and
connecting the ribbon at lead side (sometimes referred to as "second" bond) with the addition of material, namely using (any of) conductive tape, glue or solder as interface material between the ribbon and the substrate (leadframe).

Ribbons can be easily shaped and cannot become misplaced due to the leadframe handling.

An interface material can improve joint condictivity, so that the device substrate (leadframe) will not be stressed by the ultrasonic power.

Four candidate options can be considered for that purpose:
conductive tape (also referred to as "film") provided as interface material between ribbon and substrate (leadframe);
glue/solder paste dispensed before a ribbon bonding step
glue/solder paste dispensed after a ribbon bonding step
glue/solder paste dispensed both before and after a ribbon bonding step.

Solutions as described herein offer one or more of the following advantages:
connections are aligned by ribbon bonding equipment (current ribbon bonding equipment may provide a degree of accuracy in the range of +-3 microns);
no mechanical stress at the substrate side (no ultrasonic applied to the leads);
no additional features involved in substrate (leadframe) design in order to strengthen it, which translates into more room available for allocating further package positions on a leadframe, with cost saving; and

fast design and cost effectiveness.

By way of constrast to conventional solutions as discussed in the foregoing, in various solutions proposed herein - at the lead side, namely at the end coupled to a lead (so called "second" bond) - ribbons are connected with the addition of material, namely using conductive tape, glue or solder as interface material between the ribbon and the leadframe.

In that way, at the lead side the conductive ribbon is not welded to a lead.

Less mechanical stress can thus be applied to the structure of the device, primarily by avoiding applying mechanical stress (ultrasound) to the substrate structure at the leads, while retaining the inherent advantages of ribbons.

### Brief description of the several views of the drawings

One or more embodiments will now be described, by way of example only, with reference to the annexed figures, wherein:
Figure 1 is a plan view illustrative of the structure of a power semiconductor device;
Figure 2 is a cross-sectional view of an electrical connection provided via a ribbon according to a first option described herein;
Figure 3 is a cross-sectional view of an electrical connection provided via a ribbon according to a second option described herein;
Figure 4 is a cross-sectional view of an electrical connection provided via a ribbon according to a third option described herein;
Figure 5 is a cross-sectional view of an electrical connection provided via a ribbon according to a fourth option described herein;
Figure 6 is flow-chart illustrative of possible steps in implementing the first option described herein;
Figure 7 is flow-chart illustrative of possible steps in implementing the second option described herein;
Figure 8 is flow-chart illustrative of possible steps in implementing the third option described herein;
Figure 9 is flow-chart illustrative of possible steps in implementing the fourth option described herein; and
Figures 10 to 13 are plan views of a portion of a (integrated circuit) semiconductor device during implementation of the fourth option described herein.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

Also, when an element is described as "connected to" or "coupled to" another element, it should be understood that still another element may be interposed therebetween, as well as that the element may be connected or coupled directly to another element.

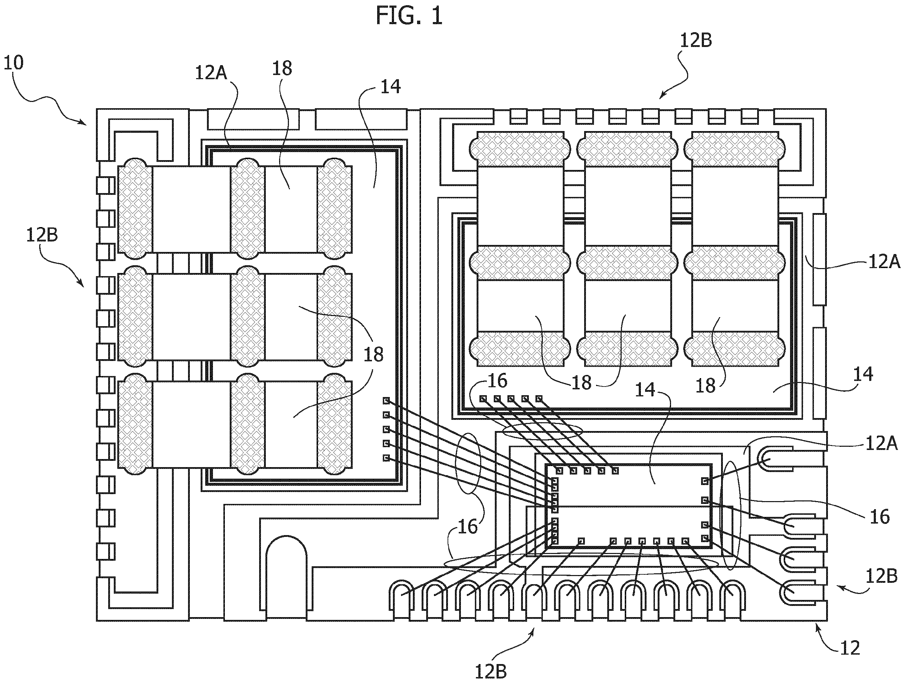

Figure 1 illustrates the structure of a power (integrated circuit, IC) semiconductor device 10 comprising (this is visible at the bottom right-hand side of Figure 1) a low-power section 12 (a controller die or chip, for instance) attached on a first die pad 12A in a leadframe 12 and a high-power section, including, for instance, two power dice or chips 14 attached on further respective die pads 12A in the leadframe 12.

As used herein, the terms chip/s and die/dice are regarded as synonymous.

An array including plural sets of leads 12B is arranged around the die pads 12A having the low-power and the high-power dice 14 mounted thereon.

As illustrated herein by way of example, an integrated circuit semiconductor device such as the device 10 comprises, in addition to a substrate (leadframe) 12 having one or more semiconductor chips or dice 14 arranged thereon, electrically conductive formations 16, 18 coupling the semiconductor chip(s) 14 to leads (outer pads) 12B in the substrate.

An insulating encapsulation (an epoxy resin, for instance, not visible in the figures for simplicity) is molded on the assembly thus formed to complete the plastic body of the device 10.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a substrate such as a leadframe 12 comprises an array of electrically-conductive formations (or leads 12B, for instance) that from an outline location extend inwardly in the direction of a semiconductor chip or die (for instance, 14) thus forming an array of electrically-conductive formations from a die pad (for instance, 12A) configured to have at least one (IC) semiconductor chip or die attached thereon. This may be via conventional means such as a die attach adhesive (a die attach film or DAF, for instance).

In certain cases, the substrate 12 can be of the pre-molded type, that is a type of leadframe comprising a sculptured metal (copper, for instance) structure formed by etching a metal sheet and comprising empty spaces that are filled by an insulating compound (a resin, for instance) "pre-molded" on the sculptured metal structure.

In current manufacturing processes of semiconductor devices, plural devices are manufactured concurrently to be separated into single individual device in a final singulation step.

For simplicity and ease of explanation, the following description will refer to manufacturing a single device.

As noted, electrically conductive formations 16, 18 are provided coupling the semiconductor chip(s) 14 to selected ones of the leads (outer pads) 12B in the substrate.

In power semiconductor devices such as the device 10 illustrated in Figure 1, the current transferred from the high-power section to the output pads 12B of the device can be significant. For that reason, providing electrical coupling (that is, electrically coupling the power die 14 to the leads 12B) for the high-power sector via simple wire-bonding may be unsatisfactory and other methods are conventionally used.

For instance, as illustrated in Figure 1, so-called ribbons 18 can be used for that purpose in the place of wires. Wires 16 can still be used to provide electrical coupling to the low-power section 14 (a controller, for instance) in the device 10.

That is, as illustrated in Figure 1, electrically conductive formations are provided comprising wire bonding patterns 16 coupling the low-power section (bottom right-hand corner in Figure 1) to selected ones of the leads 12B.

These wire bonding patterns are coupled to die pads provided at the front or top surfaces of the chips.

Conversely, ribbons 18 can be used to couple the high-power section (top and left-hand side of Figure 1) to selected ones of the leads 12B acting as (power) output pads of the device 10. Using ribbons in the place of wires takes into account the fact that the current transferred from the high-power section to the output pads in a power semiconductor device may be significant.

As noted, ribbons 18 facilitate providing electrical coupling to the high-power section of a device 10.

Ribbons 18 are electrically conductive strip-like formations (of a metallic material such as copper, copper alloy, aluminum, or other conductive materials compatible with ultrasonic bonding, for instance) comprising a central portion and two opposed terminal parts 181, 182 configured to contact die bonding pads 140 on the dice 14 and selected ones of the leads 12B in order to provide electrical coupling therebetween.

The terminal parts or ends 181, 182 of the ribbons 18 may be bonded to the underlying die bonding pads 140 and the leads 12B via ultrasonic wedge-bonding technique as known to those skilled in the art.

Ultrasonic wedge-bonding is based on the application of ultrasound and (mechanical) pressure to form an electrical connection between the terminal parts 181, 182 of a ribbon and an underlying surface (the die bonding pad 140 or the lead 12B).

While advantageous, wedge-bonding may have undesired effects on the device structure as a consequence of the mechanical stress applied during bond formation.

For instance, ultrasonic wedge-bonding may undesirably damage the leadframe 12. In certain cases, deformation and/or laceration of the leadframe 12 (especially in proximity to the leads 12B) may cause the device under processing to be discarded, thus increasing overall manufacturing time and costs.

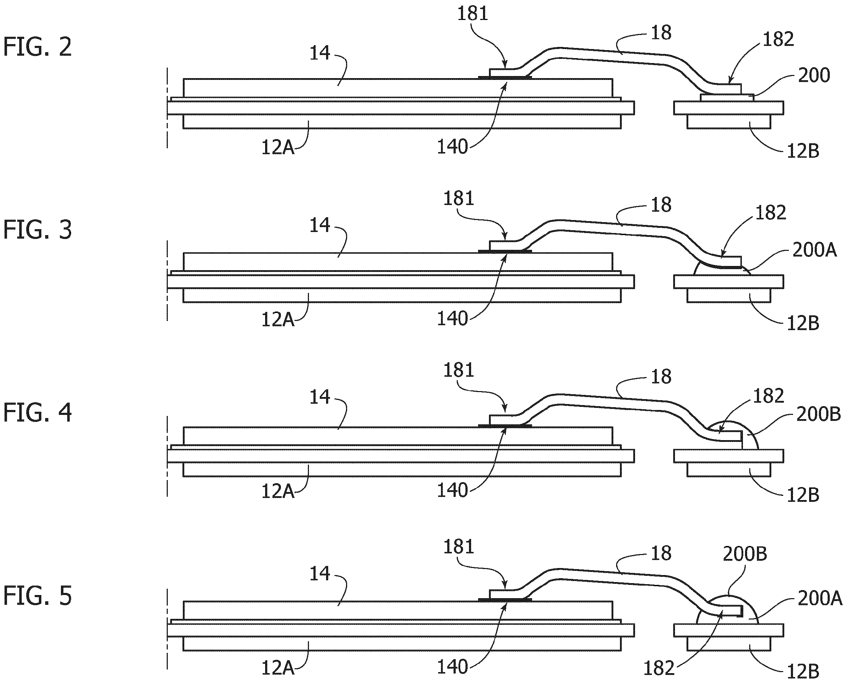

Solutions as described herein are based on a "hybrid" ribbon bonding technique comprising:
at the die side, namely at the end 181 coupled to a die pad 140 on the die or chip 14 (so called "first" bond, left-hand side in Figures 2 to 5), ribbons 18 are welded using standard ultrasonic bonding tools and technology, and
at the lead side, namely at the end 182 coupled to a lead 12B (so called "second" bond, right-hand side in Figures 2 to 5) ribbons 18 are connected with the addition of material, namely using conductive tape, glue or solder as interface material between the ribbon 18 and the leadframe 12.

Less mechanical stress can thus be applied to the structure of the device 10, primarily by avoiding applying mechanical stress (ultrasound) to the substrate structure at the leads 12B, while retaining the inherent advantages of ribbons.

Figures 2 to 5 are longitudinal cross-sectional views of an electrical connection provided via a ribbon 18 according to various possible options described herein.

In the exemplary cases illustrated in Figures 2 to **5****,** a ribbon 18 is assumed to be welded at the die side, namely at the end 181 coupled to a die pad 140 on the die or chip 14 (so called "first" bond) using standard ultrasonic bonding equipment tools and technology.

In the exemplary cases illustrated in Figures 2 to 5, at the lead side, namely at the end 182 coupled to a lead 12B (so called "second" bond) a ribbon 18 is assumed not to be welded but merely caused to rest on the lead 12B during the bonding step at the die side, namely at the end 181 with an interface material provided between the ribbon 18 and the lead 12B at the lead side, namely at the end 182.

In a first possible option as illustrated in Figure 2, electrically conductive laminar material 200 such as tape (or "film", of any type known to those of skill in the art of manufacturing semiconductor devices) is provided as interface material between the end 182 of the ribbon 18 and the lead 12B.

In a second possible option as illustrated in Figure 3, electrically conductive glue/solder paste 200A (of any type known to those of skill in the art of manufacturing semiconductor devices) is dispensed as interface material between the end 182 of the ribbon 18 and the lead 12B before ribbon bonding.

In a third possible option as illustrated in Figure 4, electrically conductive glue/solder paste 200B is dispensed as interface material between the end 182 of the ribbon 18 and the lead 12B after ribbon bonding.

In a fourth possible option as illustrated in Figure 5, electrically conductive glue/solder paste is dispensed as interface material between the end 182 of the ribbon 18 and the lead 12B both before (see reference 200A) and after (see reference 200B) ribbon bonding.

Steps according to any of the options discussed in the foregoing can be advantageously implemented in an (otherwise conventional) apparatus configured for ribbon wedge bonding plus other conventional steps (applying die attach film, dispensing electrically conductive glue or solder paste, reflow, and so on); in this way, no substantial additional processing steps are added to the manufacturing process.

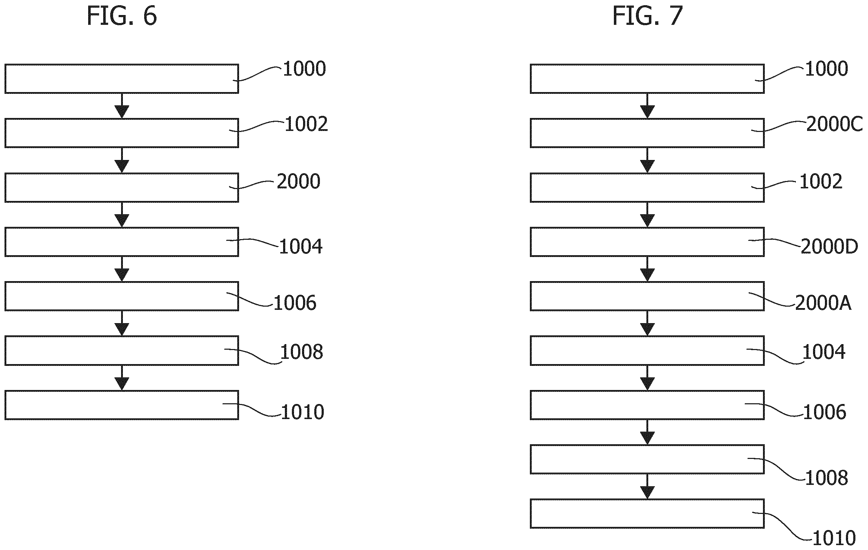

This is highlighted in the flow-charts of Figures 6 to 9.

It will be otherwise appreciated that the sequence of steps of Figures 6 to 9 is merely exemplary insofar as:
one or more steps illustrated in Figures 6 to 9 can be omitted, performed in a different manner (with other tools, for instance) and/or replaced by other steps;
additional steps may be added;

one or more steps can be carried out in a sequence different from the sequence illustrated.

Figure 6 is flow-chart illustrative of possible steps in implementing the first option described herein in connection with Figure 2 (laminar material such as conductive tape 200 added as interface material between ribbon 18 and lead 12B).

The blocks in the flow-chart of Figure 6 are illustrative of the following steps:
wafer sawing - block 1000;
die attach - block 1002;
tape attach on leadframe (at the leads 12B, for instance) - block 2000
ribbon bonding (to the dice 14, via ultrasound at the end 181) - block 1004;
reflow - block 1006;
encapsulation molding - block 1008;
package singulation - block 1010.

The steps represented by blocks 1000, 1002, 1004, 1006, 1008, and 1010 are per se known in the art and are also contemplated in the flow charts of Figure 7, Figure 8 and Figure 9, where they are indicated with the same reference numerals.

Tape attach on leadframe (as represented by block 2000 in Figure 6) may take advantage of the fact that the laminar material (conductive tape or film) 200 provided as interface material between ribbon 18 and lead 12B can be a same type of laminar material as the die attach film (DAF) used for attaching a die 14 onto a respective die pad 12A in a step as represented by block 1002.

An underlying principle is thus that the (at least one) semiconductor die 14 can be attached to the substrate 12 via electrically conductive material (tape or film) of the same type added at the second end portion 182 of the electrically conductive ribbon 18.

Figure 7 is a flow-chart illustrative of possible steps in implementing the second option described in connection with Figure 3, where electrically conductive glue/solder paste 200A is dispensed as interface material between the end 182 of the ribbon 18 and the lead 12B before ribbon bonding.

As noted, the steps represented by blocks 1000, 1002, 1004, 1006, 1008, and 1010 are per se known in the art and can be essentially the same already introduced in connection with Figure 6.

In the flow-chart of Figure 7 glue/solder paste dispensing on the leads 12B (as represented by block 2000A prior to ribbon bonding at the block 1004) may take advantage of the fact that the interface material 200A between the ribbon 18 and the lead 12B may comprise the same type of glue/solder paste dispensed on the die 14 in a step 2000C after wafer sawing at the step 1000 in order to facilitate attaching a die 14 onto a respective die pad 12A: this may occur in the step of block 1002 followed by a reflow step as represented by the block 2000D.

Here again an underlying principle is thus that the (at least one) semiconductor die 14 can be attached to the substrate 12 via electrically conductive material (glue/solder paste) of the same type added at the second end portion 182 of the electrically conductive ribbon 18.

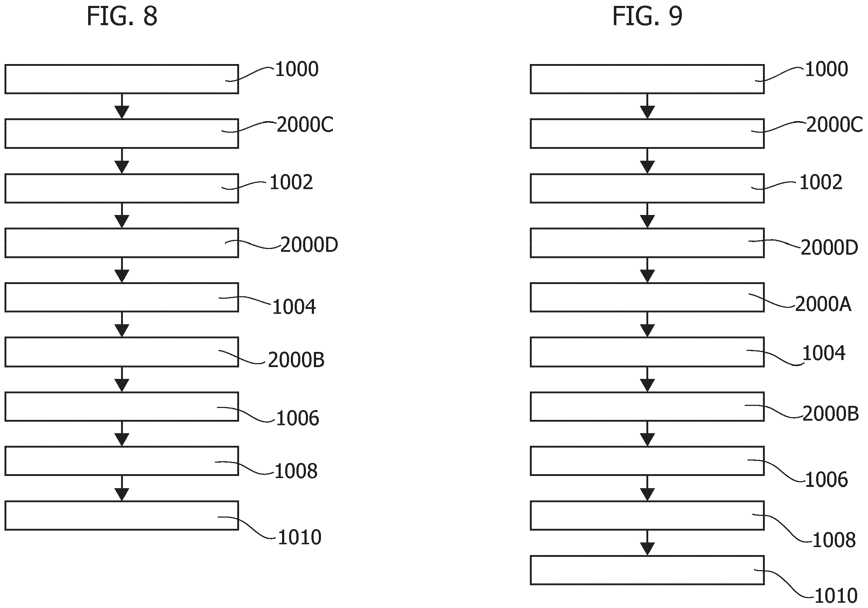

Figure 8 is a flow-chart illustrative of possible steps in implementing the third option described in connection with Figure 4, where electrically conductive glue/solder paste 200A is dispensed as interface material between the end 182 of the ribbon 18 and the lead 12B after ribbon bonding.

Once more, the steps represented by blocks 1000, 1002, 1004, 1006, 1008, and 1010 are per se known in the art and can be essentially the same already discussed in connection with Figure 6 and Figure 7.

In the flow-chart of Figure 8 glue/solder paste dispensing at the end 182 of the ribbon (as represented by block 2000B after ribbon bonding at the block 1004) may take advantage of the fact that the interface material 200B dispensed on the end 182 of the ribbon 18 may be the same type of glue/solder paste dispensed on the die 14 in a step 2000C after wafer sawing at the step 1000 in order to facilitate attaching a die 14 onto a respective die pad 12A in the step of block 1002 followed by a reflow step as represented by the block 2000D.

Once more, an underlying principle is thus that the (at least one) semiconductor die 14 can be attached to the substrate 12 via electrically conductive material (glue/solder paste) of the same type added at the second end portion 182 of the electrically conductive ribbon 18.

Figure 9 is a flow-chart illustrative of possible steps in implementing the fourth option described in connection with Figure 5 (electrically conductive glue/solder paste 200A, 200B dispensed as interface material at the end 182 of the ribbon 18 and the lead 12B both before and after ribbon bonding).

Once more, the steps represented by blocks 1000, 1002, 1004, 1006, 1008, and 1010 are per se known in the art and can be essentially the same already discussed in connection with Figures 6 to 8.

In the flow-chart of Figure 9 glue/solder paste dispensed on the leads 12B (as represented by block 2000A prior to ribbon bonding at the block 1004) and at the end 182 of the ribbon (as represented by block 2000B after ribbon bonding at the block 1004) may once more take advantage of the fact that the interface material 200A, 200B may be the same type of glue/solder paste dispensed on the die 14 in a step 2000C after wafer sawing at the step 1000 in order to facilitate attaching a die 14 onto a respective die pad 12A in the step of block 1002 followed by a reflow step as represented by the block 2000D.

Once more, an underlying principle is thus that the (at least one) semiconductor die 14 can be attached to the substrate 12 via electrically conductive material (glue/solder paste) of the same type added at the second end portion 182 of the electrically conductive ribbon 18.

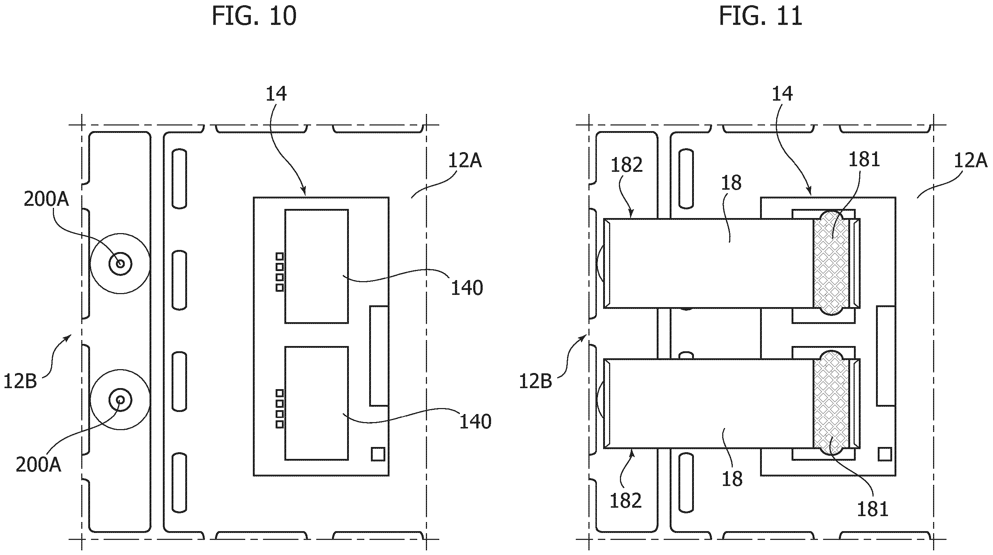

Figures 10 to 13 are top views of a portion of a (integrated circuit) semiconductor device during implementation of the fourth option described herein in connection with Figure 5 and Figure 9.

This solution was found to be particularly advantageous in achieving a robust, reliable electrical coupling between ribbons 18 and leads.

Figure 10 is illustrative of a condition where glue 200A has been dispensed on top of a lead 12B at locations where ribbons 18 are intended to be placed.

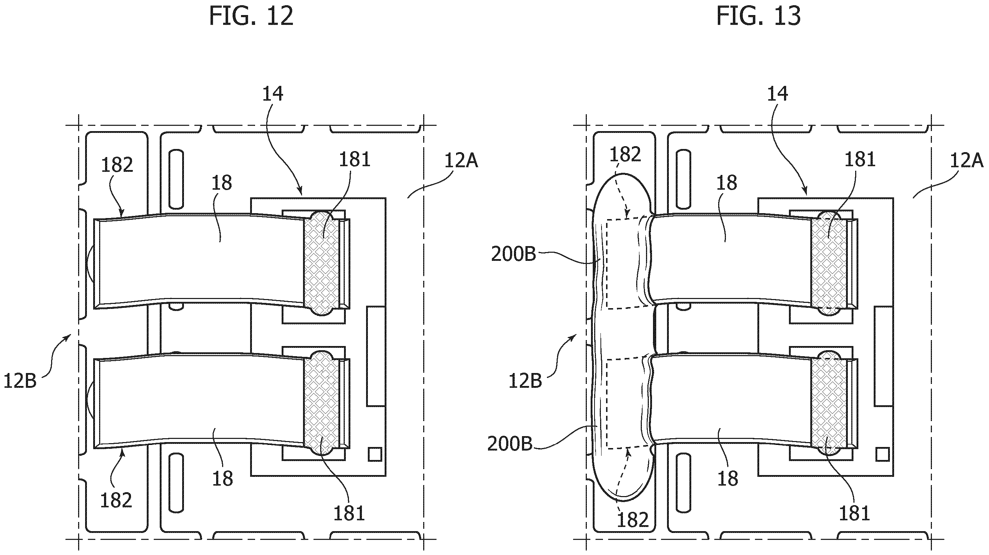

Figure 11 (a top view) and Figure 12 (a side view under a 30° observation angle) are illustrative of a condition where ribbons 18 have been welded at the die side (ends 181) using ultrasonic bonding, while at lead side (ends 182) they are just resting on the leads 12B.

Finally, Figure 13 (again a side view under a 30° observation angle) is illustrative of a condition where (further) glue 200B has been dispensed on top of the ribbons 18 at the lead side (ands 182) in order to facilitate conductive ribbon-to-lead connection.

It will be appreciated that when an element is described herein as "connected to" or "coupled to" another element, it should be understood the element may be connected or coupled directly to another element as well as that still another element may be interposed therebetween.

For instance, the first end portion 181 of the electrically conductive ribbon 18 visible in figures such as Figures 2 to 8 is ultrasonically coupled to the semiconductor die 14 by ultrasonically coupling (that is, ultrasonically bonding or wedge bonding as also called in the art) the end portion 181 of the ribbon 18 to a die pad 140 included in the (integrated circuit) semiconductor chip or die 14.

Likewise, the second end portion 182 of the electrically conductive ribbon 18 is coupled to the lead 12B via electrically conductive laminar material such as the film or tape 200 (Figure 2) or via the glue or solder paste 200A, 200B (Figures 3 to 5) provided at the second end portion 182 of the ribbon 18.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
arranging at least one semiconductor die (14) on a substrate (12) having electrically conductive leads (12B), and
providing electrical coupling of the at least one semiconductor die (14) via at least one electrically conductive ribbon (18) having a first end portion (181) electrically coupled to the at least one semiconductor die (14) and a second end portion (182) electrically coupled to at least one lead (12B) out of said electrically conductive leads (12B), respectively,
wherein the method comprises:
ultrasonically coupling (1004) the first end portion (181) of the electrically conductive ribbon (18) to the at least one semiconductor die (14), and
coupling the second end portion (182) of the electrically conductive ribbon (18) to the at least one lead (12B) via electrically conductive material (200, 200A, 200B) added (2000; 2000A, 2000B) at the second end portion (182) of the electrically conductive ribbon (18), wherein the electrically conductive material includes conductive tape (200), glue or solder paste (200A, 200B).

2. The method of claim 1, comprising:
coupling (2000) the second end portion (182) of the electrically conductive ribbon (18) to the at least one lead (12B) via conductive tape (200) arranged therebetween, and
attaching (1002) the at least one semiconductor die (14) on the substrate (12) via conductive tape (200) electrically arranged therebetween.

3. The method of claim 1, comprising coupling (2000A, 2000B) the second end portion (182) of the electrically conductive ribbon (18) to the at least one lead (12B) via electrically conductive glue or solder paste (200A, 200B) dispensed at the second end portion (182) of the electrically conductive ribbon (18), wherein the electrically conductive glue or solder paste (200A) is dispensed (2000A) onto the at least one lead (12B).

4. The method of claim 1, comprising coupling the second end portion (182) of the electrically conductive ribbon (18) to the at least one lead (12B) via electrically conductive glue or solder paste (200B) dispensed (2000A, 2000B) at the second end portion (182) of the electrically conductive ribbon (18), wherein the electrically conductive glue or solder paste (200A, 200B) is dispensed (2000A, 2000B) both onto the at least one lead (12B) and onto the second end portion (182) of the electrically conductive ribbon (18).

5. The method of claim 3 or claim 4, comprising attaching (2000C) the at least one semiconductor die (14) on the substrate (12) via electrically conductive glue or solder paste.

6. A device (10), comprising:
at least one semiconductor die (14) arranged on a substrate (12) having electrically conductive leads (12B), and
at least one electrically conductive ribbon (18) electrically coupling the at least one semiconductor die (14), wherein the at least one electrically conductive ribbon (18) has a first end portion (181) electrically coupled to the at least one semiconductor die (14) and a second end portion (182) electrically coupled to at least one lead (12B) out of said electrically conductive leads (12B), respectively,
wherein:
the first end portion (181) of the electrically conductive ribbon (18) is ultrasonically coupled to the at least one semiconductor die (14), and
the second end portion (182) of the electrically conductive ribbon (18) is coupled to the least one lead (12B) via electrically conductive material (200, 200A, 200B) added at the second end portion (182) of the electrically conductive ribbon (18), wherein the electrically conductive material includes conductive tape (200), glue or solder paste (200A, 200B).
